# EUROPÄISCHE PATENTANMELDUNG

(11) **EP 1 263 030 A2**
(43) Veröffentlichungstag der Anmeldung: **04.12.2002**
(21) Anmeldenummer: 02012019.2
(22) Anmeldetag: 31.05.2002
(51) Int. Cl.: H01L 21/20, H01L 21/268

(54) **Verfahren zur Behandlung heteroepitaktischer Halbleiterschichten auf Siliziumsubstraten**

(30) Priorität: 02.06.2001 DE 10127073
(71) Anmelder: Forschungszentrum Rossendorf e.V., 01328 Dresden (DE); EADS Deutschland GmbH, 85521 Ottobrunn (DE)
(72) Erfinder: Gebel, Thoralf, 01465 Dresden-Langenbrück (DE); Panknin, Dieter, Dr., 01277 Dresden (DE); Voelskow, Matthias, Dr., 01279 Dresden (DE); Heera, Viton, Dr., 01279 Dresden (DE); Skorupa, Wolfgang, Dr., 01108 Dresden-Weixdorf (DE); Eickhoff, Martin, Dr., 85737 Ismaning (DE)

(57) **Zusammenfassung**

Die Erfindung betrifft ein Verfahren zur Behandlung heteroepitaktisch auf Siliziumsubstraten abgeschiedener Halbleiterschichten. Die Erfindung soll insbesondere für die Herstellung elektronischer Bauelemente eingesetzt werden.

Die Erfindung beinhaltet, dass die Oberfläche der Epitaxieschicht ganzflächig mit einem Lichtimpuls zwischen 2 und 500 ms der Energiedichte von 100 bis 200 Joule/cm² und einem Intensitätsmaximum der Wellenlänge zwischen 400 und 600 nm bestrahlt wird.

Dabei kann als heteroepitaktische Halbleiterschicht 3C-SiC eingesetzt werden.

Es können auch eine Vorheizung des Siliziumsubstrates und mehrere aufeinanderfolgende Lichtblitze verwendet werden.

## Beschreibung

Die Erfindung betrifft ein Verfahren zur Behandlung heteroepitaktisch auf Siliziumsubstraten abgeschiedener Halbleiterschichten. Die Erfindung soll insbesondere für die Herstellung elektronischer Bauelemente eingesetzt werden.

Einkristallines Siliziumkarbid - nachfolgend auch als SiC bezeichnet - besitzt gegenüber Silizium eine Reihe von Eigenschaften, welche für eine Vielzahl von Anwendungen in der Elektronik von großem Interesse sind, wie z.B. die Möglichkeit des Einsatzes bei hohen Temperaturen, in aggressiver Umgebung oder für strahlenresistente Anwendungen.

Demgegenüber betragen allerdings die Kosten zur Herstellung einkristalliner Siliziumkarbidwafer ein Vielfaches derer zur Herstellung von Si-Wafern, da das Material nicht aus der Schmelze gezogen werden kann, sondern üblicherweise durch Abscheidung aus der Gasphase aufwächst. Des weiteren gelingt es bisher nicht, große SiC-Waferdurchmesser, vergleichbar denen in der Si-Technologie ( 300 mm ) herzustellen.

Üblicherweise beträgt die notwendige Materialdicke, in denen elektronische Bauelemente erzeugt werden, in modernen Technologien nur einige Mikrometer. Das bedeutet aber, dass beispielsweise eine mehrere Mikrometer dünne, auf einem Träger aufgebrachte SiC-Schicht bereits alle Anforderungen für eine SiC-Technologie mit den oben genannten Vorteilen erfüllen müsste, wenn es gelänge, diese Schichten einkristallin herzustellen.

Seit einigen Jahren wird intensiv daran gearbeitet, Siliziumkarbid heteroepitaktisch auf Silizium als Trägermaterial mit Hilfe von CVD- oder MBE-Prozessen abzuscheiden, um somit die Vorteile der großen Waferdurchmesser und der billigen Substrate zu nutzen (F. Bonzo, J. T. Yates, W.J. Choyke, L. Muehlhoff, J. Appl. Phys. 57 ( 1985 ) p. 2771, S. Nishino, J.A. Powell, H.A. Will, Appl- Phys. Lett. 42 ( 1983 ) p. 460). Aufgrund der hohen Gitterfehlanpassung von ca. 21 % zwischen SiC und Si treten Spannungen und Defekte, besonders an der Phasengrenze SiC/Si auf. Das bedeutet, dass besonders die Eigenschaften der SiC-Schicht zu Beginn der Abscheidung entscheidend für die Kristallqualität des SiC sind. Zur Verbesserung der Schichtqualität wird zu Beginn der Abscheidung der CVD-Schicht eine Karbonisierung der Si-Oberfläche in C₃H₈ durchgeführt. Dadurch entsteht eine dünne Übergangsschicht, die dann als Keim für das Wachstum der SiC-Schicht im CVD-Prozeß dient (V. Camilla, K.V. Karagodina, J. Petzoldt G. Eichhorn, Mater. Sci. Eng. B 29 ( 1994 ) 170). Trotzdem führen die Unterschiede in den Gitterkonstanten von Si und SiC zu einer sehr hohen Defektkonzentration im Anfangsstadium der Abscheidung (∼1x10¹²cm⁻² ), die mit zunehmender SiC-Schichtdicke abnimmt (∼1x10⁹ cm⁻² bei 2.5 um Schichtdicke ) (J. Stoemenos, C. Dezauzier. C. Arnaud, J. Camassel, J. Pasqual, J. L. Robert, Mat. Sci. Eng. B 29 (1995) 160). Desweiteren beobachtet man beim Epitaxieprozeß das Entstehen großer Si-Einschlüsse im Silizium (cavities) unterhalb der Epitaxieschicht (K. Zekendes, V. Papaioannou, B. Pecz and J. Stoemenos, J. Crys. Growth 157 ( 1995 ) p. 329).

Der Erfindung liegt die Aufgabe zugrunde, ein Verfahren vorzuschlagen, mit dem auf Silizium abgeschiedene defektreiche Siliziumkarbidschichten in weitgehend defektfreien Schichtaufbau auf Silizium umgewandelt werden. Die Erfindung soll insbesondere zur Verbesserung der Qualität von Schichten für die Herstellung elektronischer Bauelemente dienen.

Erfindungsgemäß wird die Aufgabe mit den in den Patentansprüchen dargelegten Merkmalen gelöst. Dabei ist wesentlich, dass die Silizium-Substrate, auf denen durch einen CVD-Prozess SiC mit relativ hoher Defektdichte epitaktisch abgeschieden wurde, einem kurzzeitigen intensiven Lichtimpuls, beispielsweise von Blitzlampen ausgesetzt werden, wobei die Wellenlänge des Lichtes so gewählt ist, dass nur ein geringer Teil der Strahlung in der defektreichen SiC-Oberflächenschicht und der Großteil der Strahlung in der Si/SiC-Grenzfläche und im oberflächennahen Bereich des Si-Substrates absorbiert wird, wobei eine dünne Oberflächenschicht des Siliziumsubstrates ganzflächig und homogen aufgeschmolzen wird. Die Dicke der homogen, ganzflächig und kurzzeitig aufgeschmolzenen Silizium-Grenzschicht wird durch eine geeignete Wahl der Bestrahlungsparameter, wie Energiedichte und Impulslänge auf einige Hundert Nanometer begrenzt. Aufgrund des kurzen Strahlungsimpulses, der hohen Wärmeleitfähigkeit des SiC und der begrenzten Wärmeleitfähigkeit des Si-Substrates und eines daraus resultierenden Temperaturgradienten in Richtung der Substratrückseite des Si-Wafers werden die Bereiche unterhalb der angeschmolzenen Si-Schicht bei niedrigerer Temperatur gehalten und somit eine nachteilige Wirkung auf das Substrat vermieden. Der Prozeß an der Phasengrenze ist adiabatisch, was zu einem Ansteigen der Temperatur und zur Auflösung einer schmalen, 10 nm dicken, SiC-Schicht an der Phasengrenze und zum Abbau der Spannungen an der Phasengrenze führt.

Infolge der hohen Wärmeleitfähigkeit des SiC werden die Defekte oberhalb der aufgelösten SiC-Schicht ausgeheilt. Während des Abkühlungsprozesses findet eine Phasenseparation mit Rekristallisation statt.

Aufgrund der geringen SiC-Schichtdicke und der hohen Wärmeleitfähigkeit von Siliziumkarbid tritt nur sehr geringer Temperaturgradient zur Scheibenoberfläche hin auf. Damit führt die hohe Temperatur, auf der sich die SiC-Schicht befindet und die gleich der Silizium-Schmelztemperatur ist, zur Ausheilung der Defekte in der gesamten SiC-Schicht.

Die Verweilzeit der SiC-Schicht auf dieser für die Defektausheilung vorteilhaften hohen Temperatur wird in erster Linie bestimmt durch die Dicke des aufgeschmolzenen Si-Oberflächenfilmes. Das resultiert daraus, dass nach der Beendigung des Lichtimpulses mit einer Dauer im Millisekundenbereich der Erstarrungsprozeß des geschmolzenen Si-Filmes vom Substrat her einsetzt und dabei ständig Erstarrungswärme in Richtung SiC-Schicht nachgeliefert wird.

Die Temperatur in der SiC-Schicht fällt infolge der Wärmeabstrahlung an die Umgebung erst nach der vollständigen Erstarrung der Si-Oberflächenschicht. Das heißt aber, dass die effektive Temperzeit ein Mehrfaches der Impulsdauer betragen kann.

Das Anschmelzen der grenzflächennahen Si-Schicht ist damit in mehrerer Hinsicht von Vorteil für die Qualität der SiC-Oberflächenschicht:
Erzielen einer längeren Temperzeit, als die Lichtimpulsdauer beträgt (bis zum Mehrfachen); Einstellung der effektiven Temperzeit über die Energiedichte bei der Blitzlampenbestrahlung; Temperung der SiC-Schicht bei einer konstanten und zwar der für das Substrat maximal möglichen Temperatur; Bildung eines flüssigen Si-Grenzflächenfilms, auf dem sich die SiC-Schicht ungehindert lateral entspannen kann; epitaktische Rekristallisation der aufgeschmolzenen Si-Oberflächenschicht auf dem Si-Substrat, dabei gleichzeitige Ausheilung eventueller Defekte, die beim Epitaxieprozeß an der Silizium-Oberfläche entstehen, ähnlich dem Prozeß der Laserausheilung im Flüssigphasenregime.

Die Erfindung wird nachstehend an einem Ausführungsbeispiel näher erläutert.

In der zugehörigen Zeichnung zeigt
Fig. 1 die für das Verfahren benutzte Anordnung,
Fig. 2 die schematische Darstellung der Phasen des Behandlungsprozesses des beschichteten Siliziumsubstrates mit
   a) der Ausgangssituation nach der epitaktischen Abscheidung,
   b) eine Veränderung während des ersten Lichtimpulses,
   c) die Veränderung unmittelbar nach Impulsende und
   d) das nach der Behandlung weitgehend ausgeheilte beschichtete Siliziumsubstrat.

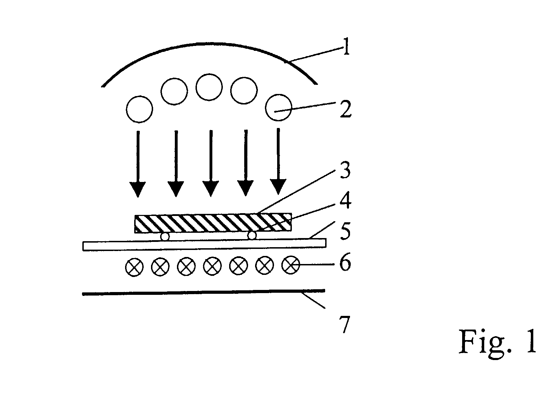

Die in Fig. 1 dargestellte Anordnung besteht aus einem Aluminium-Spiegel 1, der das Licht von Xenon-Blitzlampen 2 auf das beschichtete Substrat 3 ganzflächig fokussiert. Das Substrat 3 ist dabei auf dünnen Quarzstäben 4 gelagert und durch eine Quarzplatte 5 von einer Vorheizeinrichtung, die aus Halogenlampen 6 besteht, getrennt. Die Leistung der Halogenlampen 6 beträgt 2 kW. Unterhalb der Halogenlampen 6 ist ein weiterer Aluminium-Spiegel 7 angebracht.

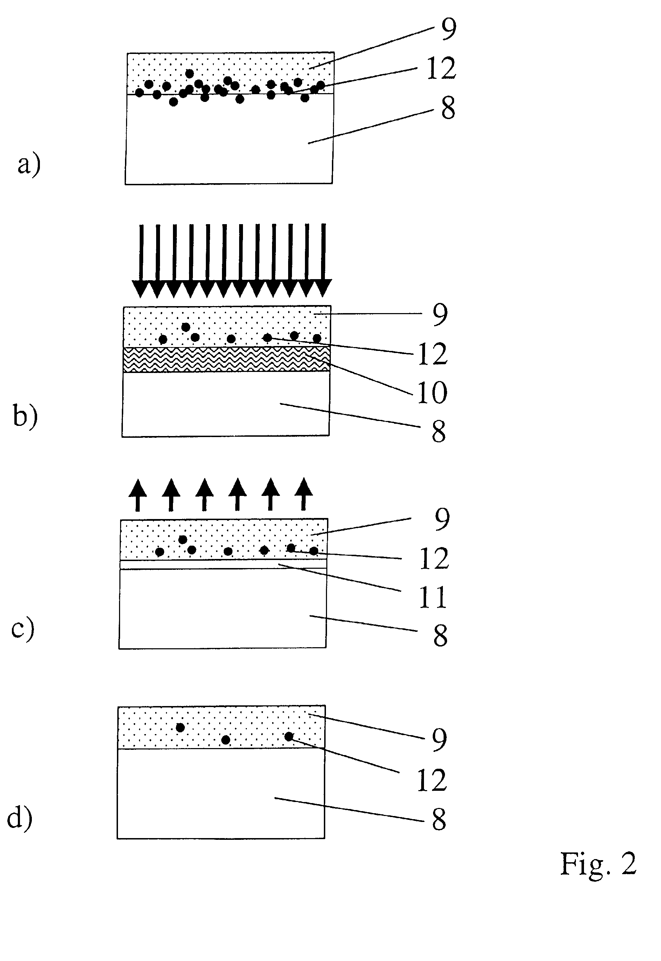

Im folgenden wird die Herstellung einer nahezu defektfreien 3C-SiC-Epitaxieschicht 9 auf einem Siliziumsubstrat 8 beschrieben (Fig. 2). Im ersten Schritt (Fig. 2a) erfolgt eine konventionelle epitaktische Abscheidung einer ca. 20 - 100 nm dicken 3C-SiC-Epitaxieschicht 9 auf einem Si-Substrat 8. Das Schichtsystem besitzt die bereits oben beschriebenen typischen Defekte 12, die sowohl in der 3C-SiC-Epitaxieschicht 9, als auch im Siliziumsubstrat 8, aber insbesondere an der Grenzfläche, auftreten .

Im zweiten Schritt wird die Scheibe zunächst durch die in Fig. 1 beschriebene Vorheizeinrichtung auf 600 - 800°C vorgeheizt und im Anschluss einem Lichtimpuls von 20 ms Dauer und einer Energiedichte von 100-150 Jcm⁻² in einer Blitzlampenanlage ausgesetzt (skizziert in Fig. 2b). Während des gesamten Prozesses befindet sich das beschichtete Substrat unter einer Argon-Atmosphäre. Das Licht der Xenon-Blitzlampen mit einem Intensitätsmaximum der Wellenlänge bei ca. 500 nm wird in dem beschriebenen Schichtsystem hauptsächlich im Bereich der stark gestörten SiC/Si- Grenzfläche absorbiert und bewirkt dort ein Aufschmelzen der Schicht 10 von der Si-Oberfläche her bis in eine Tiefe von einigen 100 Nanometern sowie die Ausheilung der Defekte 12 im Si und im SiC in Abhängigkeit von der eingestrahlten Energiedichte.

Nach Impulsende (Fig. 2c) beginnt aufgrund der sich durch Wärmestrahlung abkühlenden Si-Substrat die Kristallisation des flüssigen Si-Filmes 10 epitaktisch von der Grenzfläche zum festen Silizium her. Dabei wird ständig Wärme frei als latente Wärme, so dass der Erstarrungsvorgang dadurch verzögert wird. Aufgrund der dünnen Schicht und der hohen Wärmeleitfähigkeit der Materialien befindet sich die 3C-SiC-Epitaxieschicht 9 während der gesamten Phase des Aufschmelzens und Wiedererstarrens des Siliziums stets auf der Schmelztemperatur des Siliziums und beginnt sich erst abzukühlen, wenn die gesamte Si-Schicht als Zwischenform 11 wieder erstarrt ist. In Abhängigkeit davon, wieviel Silizium aufgeschmolzen wurde, verlängert sich proportional die Temperzeit der 3C-SiC-Epitaxieschicht 9.

Im Ergebnis der Temperung ergibt sich ein nahezu defektfreies SiC/Si Schichtsystem (Fig. 2d).

## Patentansprüche

1. Verfahren zur Behandlung heteroepitaktischer Halbleiterschichten auf Siliziumsubstraten, wobei Licht zur Behandlung eingesetzt wird, **dadurch gekennzeichnet, dass** die Oberfläche der Epitaxieschicht ganzflächig mit einem Lichtimpuls zwischen 2 und 500 ms der Energiedichte von 100 bis 200 Joule/cm² und einem Intensitätsmaximum der Wellenlänge zwischen 400 und 600 nm bestrahlt wird.

2. Verfahren nach Anspruch 1, **dadurch gekennzeichnet, dass** als heteroepitaktische Halbleiterschicht 3C-SiC eingesetzt wird.

3. Verfahren nach Anspruch 1, **dadurch gekennzeichnet, dass** das beschichtete Siliziumsubstrat mit Hilfe einer Vorheizung, beispielsweise Halogenlampen, auf eine Temperatur, kleiner als die Schmelztemperatur des Siliziumsubstrates, also unter 1412 °C, vorgeheizt wird.

4. Verfahren nach Anspruch 1, **dadurch gekennzeichnet, dass** anstelle eines Lichtimpulses mehrere zeitlich aufeinanderfolgende Lichtimpulse verwendet werden, wobei die Wartezeit zwischen den Impulsen zur Abkühlung des beschichteten Siliziumsubstrates genutzt wird.

5. Verfahren nach Anspruch 4, **dadurch gekennzeichnet, dass** die Wartezeit zwischen den Lichtimpulsen zwischen 1 Sekunde und 10 Minuten beträgt.

6. Verfahren nach Anspruch 4 , **dadurch gekennzeichnet, dass** der nachfolgende Lichtblitz gezündet wird, wenn die Temperatur des beschichteten Siliziumsubstrates 200 bis 1300 °C unter der maximalen Aufheiztemperatur liegt.

7. Verfahren nach Anspruch 1 bis 6, **dadurch gekennzeichnet, dass** die Behandlung nach einer weiteren epitaktischen Abscheidung erneut vorgenommen wird.
